# EUROPEAN PATENT APPLICATION

(11) **EP 1 737 286 A2**
(43) Date of publication of application: **27.12.2006**
(21) Application number: 06076169.9
(22) Date of filing: 06.06.2006
(51) Int. Cl.: H05K 5/06, H05K 5/00

(54) **Sealed fastenerless multi-board electronic module and method of manufacture**

(30) Priority: 20.06.2005 US 157007
(71) Applicant: Delphi Technologies, Inc., Troy, Michigan 48007 (US)
(72) Inventor: Hinze, Lee R., Kokomo, IN 46901 (US)
(74) Representative: Denton, Michael John

(57) **Abstract**

A sealed electronic module includes a housing (10) having an open end, a main circuit board (12) and at least one auxiliary circuit board (14), where the main and auxiliary circuit boards (12, 14) are both secured in the housing (10) without fasteners by a potting material (70) that is applied to the exposed face (62) of the main circuit board (12). The main circuit board (12) is peripherally supported by a housing ledge (46, 54), and the auxiliary circuit board (14) is disposed inboard of the main circuit board (12). A controlled amount of the potting material (70) applied to the exposed face (62) of the main circuit board (12) flows through one or more strategically placed apertures (64) in the main circuit board (12), forming one or more bridges of potting material (70a) between the main circuit board (12) and the underlying surface of the auxiliary circuit board (14) so that potting material (70) applied in a single step secures both circuit boards (12, 14) in the housing (10) while environmentally sealing the module.

## Description

### TECHNICAL FIELD

The present invention relates to an electronic module including multiple circuit boards disposed in a housing that is sealed with potting material, and more particularly to an arrangement for using the potting material to secure the circuit boards in the housing.

### BACKGROUND OF THE INVENTION

In the manufacture of an electronic module, one or more circuit boards populated with electronic components are inserted into a plastic or metal housing that is open on one end. In a typical application, the circuit boards are supported on one or more internal posts or flanges formed in the housing, fasteners are used to rigidly affix the circuit boards to the supports, and a sealed cover is secured to the housing to seal the module. In an alternative approach described in the U.S. Patent No. 5,703,754 to Hinze, a housing for a single circuit board is provided with an interior ledge that supports the margin of the circuit board, and the circuit board is inserted into the housing with the components facing downward so that potting material can be applied to the exposed face of the circuit board to both affix the circuit board to the housing and environmentally seal the module. While the approach disclosed by Hinze is advantageous because it eliminates the circuit board and housing cover fasteners, it does not address modules having more than one circuit board. Accordingly, what is needed is an electronic module that is sealed with potting material and configured to receive and secure two or more circuit boards without fasteners.

### SUMMARY OF THE INVENTION

The present invention is directed to a sealed electronic module and manufacturing method including a housing having an open end, a main circuit board and at least one auxiliary circuit board, where the main and auxiliary circuit boards are both secured in the housing without fasteners by a potting material that is applied to the exposed face of the main circuit board. The main circuit board is peripherally supported by a housing ledge, and the auxiliary circuit board is disposed inboard of the main circuit board. A controlled amount of the potting material applied to the exposed face of the main circuit board flows through one or more strategically placed apertures in the main circuit board, forming one or more bridges or plugs of potting material between the main circuit board and the underlying surface of the auxiliary circuit board so that potting material applied in a single step secures both main and auxiliary circuit boards in the housing while environmentally sealing the electronic module. In applications where the housing is formed of plastic or other nonconductive material, electrical interconnections among the main and auxiliary circuit boards and a connector of the electronic module are established by compliant conductor pins that protrude from housing surfaces that provide peripheral support for the main and auxiliary circuit boards.

### BRIEF DESCRIPTION OF THE DRAWINGS

FIG. 1 is an exploded isometric view of an electronic module according to this invention, including a housing, a main circuit board and an auxiliary circuit board;
FIG. 2A is an overhead isometric view of the housing of FIG. 1 prior to installation of the main and auxiliary circuit boards;
FIG. 2B is an overhead isometric view of the housing of FIG. 1 following installation of auxiliary circuit board, but prior to installation of the main circuit board;
FIG. 2C is an overhead isometric view of the housing of FIG. 1 following installation of the main and auxiliary circuit boards;
FIG. 3 is a cross-sectional view of the completed electronic module of this invention, taken along lines A-A of FIG. 2C; and
FIG. 4 is an isometric cross-sectional view of the housing of FIG. 1 prior to installation of the main and auxiliary circuit boards, showing connector pins electrically interconnecting the main and auxiliary circuit boards.

### DESCRIPTION OF THE PREFERRED EMBODIMENT

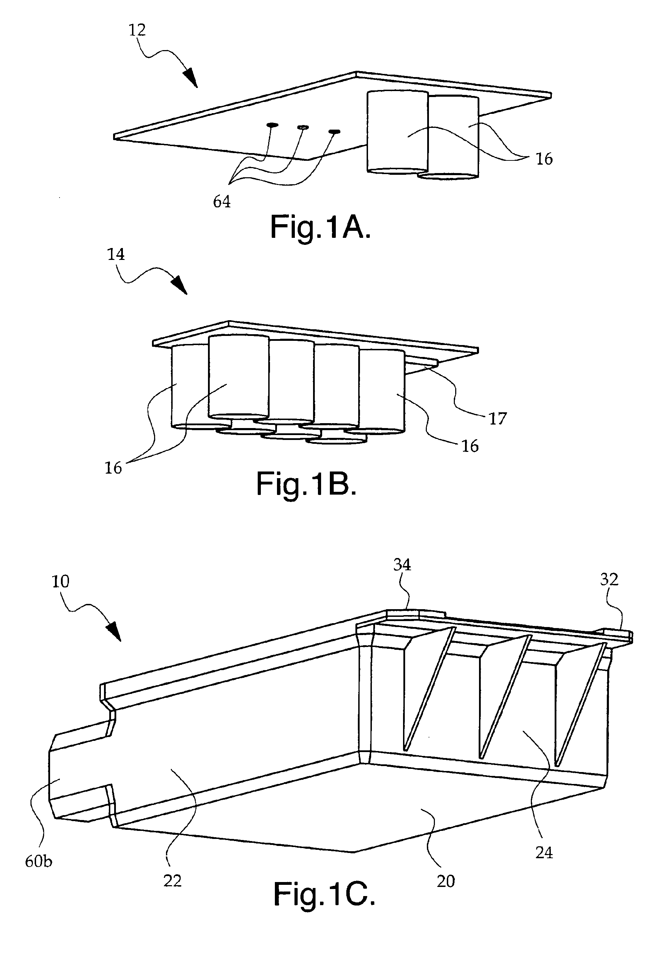

Referring to FIG. 1, the reference numerals 10, 12 and 14 respectively designate a housing, a main circuit board and an auxiliary circuit board. The main and auxiliary circuit boards 12, 14 are each populated with electronic components such as the capacitors 16 and accelerometer 17, and each board is oriented so that its major components face downward - i.e., toward the bottom 20 of housing 10. In general, the main and auxiliary circuit boards 12, 14 are installed into the housing 10 in the order depicted in FIG. 1, and then sealed in place with a potting material such as polyurethane applied to the exposed face of the main circuit board 12.

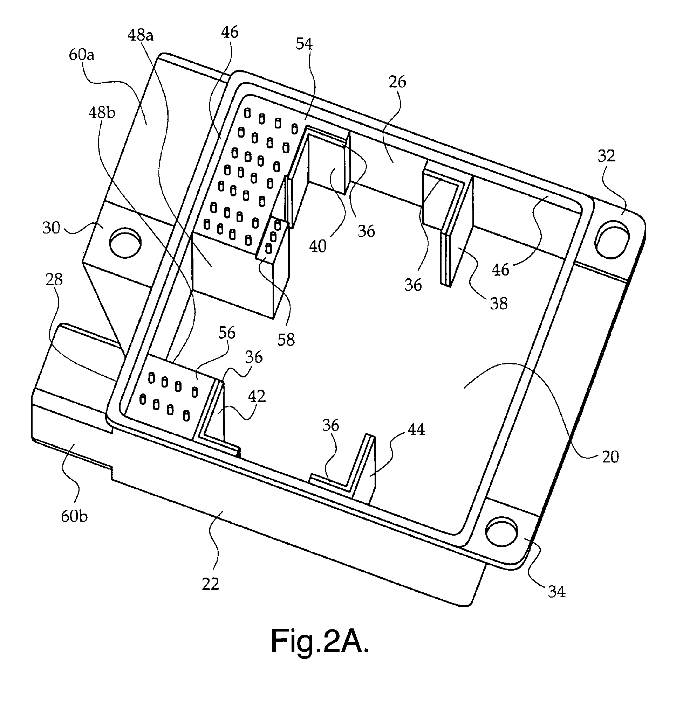

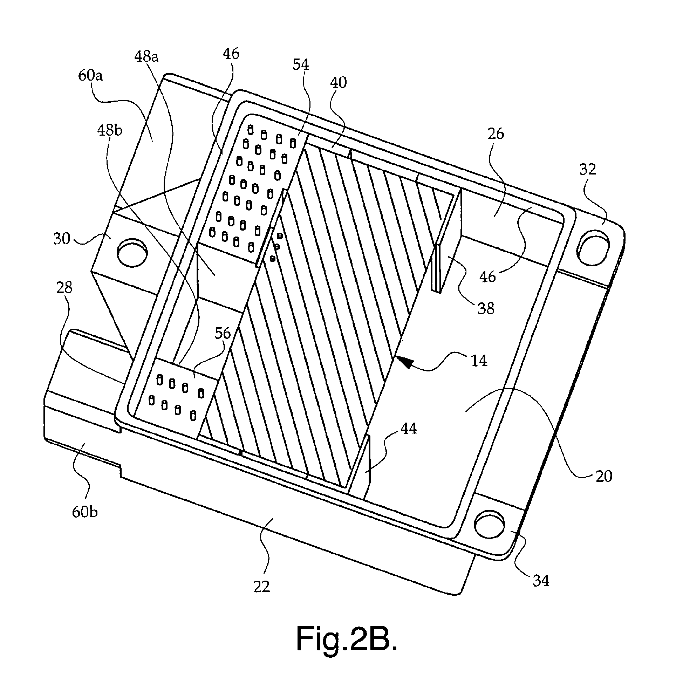

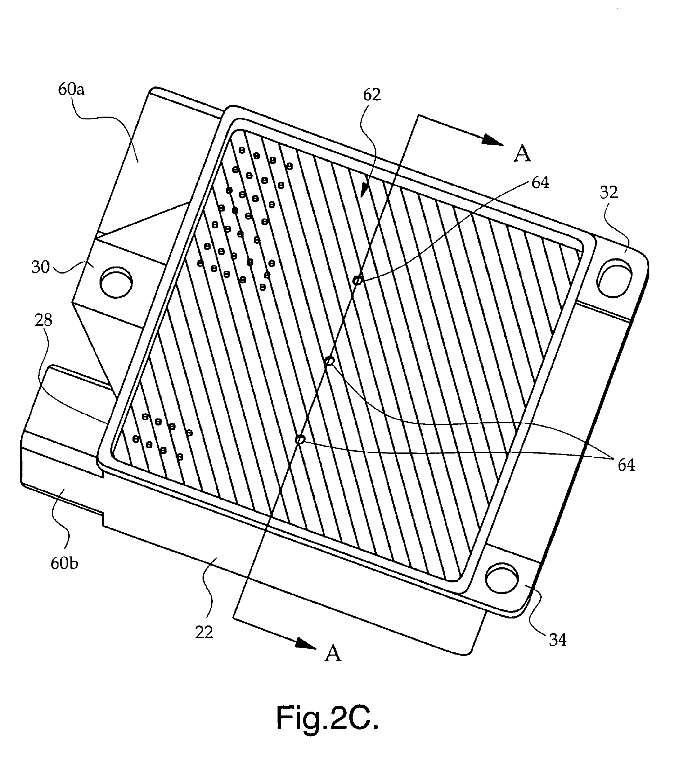

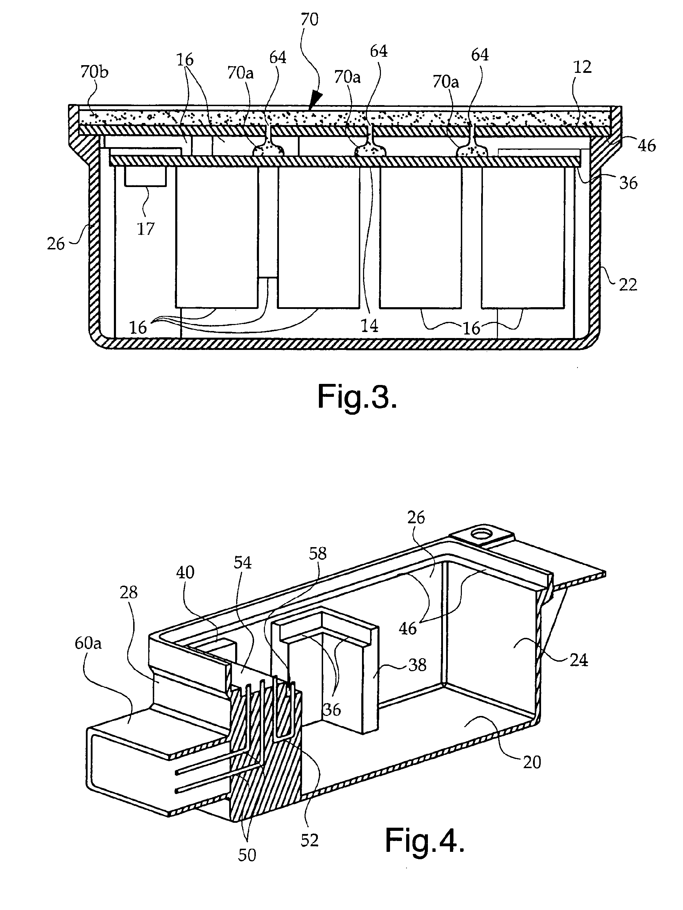

Referring additionally to FIGS. 2A-2C, the housing 10 includes side walls 22, 24, 26, 28 depending from the bottom 20 and a set of integral mounting tabs 30, 32, 34. The housing 10 is open-ended as shown to receive the populated circuit boards 12, 14. The auxiliary circuit board 14 is installed inboard of the main circuit board 12 as indicated in FIG. 1, and rests on a set of four L-shaped ledges 36 formed by four stepped L-shaped inner housing walls 38, 40, 42, 44 as illustrated in FIGS. 2B and 4. The main circuit board 12 when installed rests on a ledge 46 above the auxiliary circuit board, as illustrated in FIG. 2C. The ledge 46 is formed by a lateral offset in the housing walls 22, 24, 26, 28 and extends around the inner periphery of the housing 10 as shown in FIG. 2A.

Electrical connections among the main and auxiliary circuit boards 12, 14 and various external devices and circuits are provided by connector pins molded into a pair of connector blocks 48a, 48b. The connector blocks 48a, 48b are preferably insert-molded in the housing 10 and are disposed adjacent the housing wall 28. Referring to FIG. 4, the connector block 48a supports both L-shaped connector pins 50 (only two of which are shown) and J-shaped connector pins 52 (only one of which is shown). Although not illustrated in FIG. 4, the connector pins of connector block 48b are all L-shaped. The L-shaped connector pins 50 of connector blocks 48a, 48b protrude horizontally through the housing wall 28 and vertically through respective connector block surfaces 54, 56 that lie in the same plane as the ledge 46 that supports main circuit board 12. The J-shaped connector pins 52 of connector block 48a protrude vertically through the connector block surface 54 and a connector block surface 58 that lies in the same plane as the ledges 36 that support auxiliary circuit board 14. The terminal portions of the L-shaped connector pins 50 that protrude horizontally through the housing wall 28 are shrouded by connector headers 60a, 60b of housing 10. The terminal portions of the J-shaped connector pins 52 that protrude vertically through the connector block surface 58 electrically interconnect with plated through-holes formed in the auxiliary circuit board 14. And the terminal portions of the L-shaped and J-shaped connector pins 50, 52 that protrude vertically through the connector block surfaces 54, 56 electrically interconnect with plated through-holes formed in the main circuit board 12. Preferably, the terminal portions of the connector pins 50, 52 that protrude vertically through the connector block surfaces 54, 56, 58 are compliant and yield resiliently when passing through the circuit board through-holes so that soldered connections are not required.

According to the invention, the main and auxiliary circuit boards 12, 14 are both secured the within the housing 10 by the application of a potting material 70 such as polyurethane to the exposed face 62 of main circuit board 12. The potting material 70 is applied in a single step following installation of the main and auxiliary circuit boards 12, 14 as described above. As illustrated in FIGS. 1, 2C and 3, the main circuit board 12 is provided with a set of apertures or through-holes 64 in a portion of the circuit board that overlies the auxiliary circuit board 14. Potting material 70 deposited on the exposed face 62 of the main circuit board 12 floods a volume bounded by the exposed face 62 and portions of the housing side walls 22, 24, 26, 28 that extend above main circuit board 12. When cured, the potting material 70 adheres to the main circuit board 14 and the housing side walls 22, 24, 26, 28 to structurally bond the main circuit board 12 to the housing 10. The potting material 70 is sufficiently thin in its uncured state that it additionally flows into the apertures 64 in the main circuit board 12, forming plugs of cured potting material 70a that bridge the gap between the main and auxiliary circuit boards 12, 14 beneath the apertures 64 as shown in FIG. 3. The potting material plugs 70a structurally bond the auxiliary circuit board 14 to the main circuit board 12 (and hence, to housing 10), and vertically retain the auxiliary circuit board 14 on the ledge 36. Additionally, the layer of cured potting material 70b remaining on the exposed face 62 of main circuit board 12 serves to environmentally seal the module.

In summary, the present invention provides a sealed electronic module and manufacturing method with fastenerless support of a main circuit board and at least one auxiliary circuit board with a single application of potting material to the exposed face of the main circuit board. While the present invention has been described in reference to the illustrated embodiment, it will be recognized that various modifications will occur to those skilled in the art. For example, the housing 10 may have a shape other than rectangular, there may be more than one auxiliary circuit board, the number of potting material bridges may be different than illustrated, and so forth. Accordingly, it is intended that the invention not be limited to the disclosed embodiment, but that it have the full scope permitted by the language of the following claims.

## Claims

1. A sealed and fastenerless electronic module comprising:
first and second circuit boards (14, 12);
a housing (10) having an open end through which said first and second circuit boards (14, 12) are inserted, where said first circuit board (14) is disposed inboard of said second circuit board (12), and said second circuit board (12) closes the open end of said housing (10); and
a quantity of potting material (70) sealing said housing (10) and securing said first and second circuit boards (14, 12) within said housing (10), including a layer of potting material (70b) filling a volume defined by said housing (10) and an outboard face (62) of said second circuit board (12), and one or more plugs of potting material (70a) extending through one or more apertures (64) formed in said second circuit board (12) and bridging a gap between said first and second circuit boards (14, 12).

2. The sealed electronic module of claim 1, further comprising:
a first set of connector pins (50) electrically coupling said second circuit board (12) to a connector (60a) of said housing (10); and
a second set of connector pins (52) electrically coupling said first circuit board (14) to said second circuit board (12).

3. The sealed electronic module of claim 1, further comprising:
an upper support surface (54) for supporting a margin of said second circuit board (12) within said housing (10); and
a set of connector pins (50, 52) protruding through a portion of said upper support surface (54) and said second circuit board (12).

4. The sealed electronic module of claim 1, further comprising:
a lower support surface (58) for supporting a margin of said first circuit board (14) within said housing (10); and
a set of connector pins (52) protruding through a portion of said lower support surface (58) and said first circuit board (14).

5. The sealed electronic module of claim 1, further comprising:
a lower support surface (58) for supporting a margin of said first circuit board (14) and an upper support surface (54) for supporting a margin of said second circuit board (12); and
a set of connector pins (52) protruding at one end through said lower support surface (58) for electrical connection with said first circuit board (14), and at the other end through said upper support surface (54) for electrical connection with said second circuit board (12).

6. A method of manufacturing a sealed and fastenerless electronic module comprising the steps of:
providing a housing (10) having an open end and lower and upper support surfaces (58, 54) for supporting first and second circuit boards (14, 12), respectively, where said upper support surface (54, 46) is an interior ledge that bounds the open end of said housing (10);
placing said first circuit board (14) on the lower support surface (58) of said housing (10);
placing the second circuit board (12) on the upper support surface (54) of said housing (10) to close the open end of said housing (10); and
dispensing a quantity of potting material (70) on an exposed face (62) of said second circuit board (12) so that a first portion of said potting material (70b) covers said exposed face (62) to thereby seal said housing (10) and secure said second circuit board (12) in said housing (10), and a second portion of said potting material (70a) flows through one or more apertures (64) formed in said second circuit board (12) to form one or more bridges of potting material (70a) between said second circuit board (12) and an underlying surface of said first circuit board (14) to thereby secure said first circuit board (14) in said housing (10).

7. The method of Claim 6, including the steps of:
providing a set of electrical connector pins (50) that protrude through said upper support surface (54) for electrically coupling said second circuit board (14) to a connector (60a) of said housing (10); and
inserting terminal portions of said connector pins (50) through openings formed in said second circuit board (14) when said second circuit board (14) is placed on said upper support surface (54).

8. The method of Claim 7, where said terminal portions of said connector pins (50) yield compliantly when inserted into the openings of said second circuit board (14).

9. The method of Claim 6, including the steps of:
providing a set of electrical connector pins (52) that protrude through both said lower support surface (58) and said upper support surface (54) for electrically connecting said first circuit board (14) to said second circuit board (12);
inserting first terminal portions of said connector pins (50) through openings in said first circuit board (14) when said first circuit board (14) is placed on said lower support surface (58); and
inserting second terminal portions of said connector pins (52) through openings in said second circuit board (12) when said second circuit board (12) is placed on said upper support surface (54).

10. The method of Claim 9, where said first and second terminal portions of said connector pins (52) yield compliantly when inserted into the openings of said first and second circuit boards (14, 12).
